# EUROPEAN PATENT APPLICATION

(11) **EP 3 392 052 A1**
(43) Date of publication of application: **24.10.2018**
(21) Application number: 16875311.9
(22) Date of filing: 14.11.2016
(51) Int. Cl.: B41N 1/22, B41C 1/10, B41C 1/18, B41N 1/14, B41N 3/04, G03F 7/00

(54) **SEAMLESS OFFSET CYLINDRICAL PRINTING PLATE AND MANUFACTURING METHOD THEREFOR AND REPRODUCTION PROCESSING METHOD**

(30) Priority: 16.12.2015 JP 2015245484
(71) Applicant: Think Laboratory Co., Ltd., Kashiwa-shi Chiba 277-8525 (JP)
(72) Inventor: SHIGETA, Tatsuo, Kashiwa-shi Chiba 277-8525 (JP)
(74) Representative: Mincone, Antimo
(86) International application number: PCT/JP2016/083639
(87) International publication number: WO 2017/104327

(57) **Abstract**

Provided are a seamless cylindrical offset printing plate which enables seamless continuous printing to be performed, a manufacturing method therefor, and a reproduction processing method. The seamless cylindrical offset printing plate comprises: a cylindrical plate base material; a hydrophilic satin-like rough surface which is formed on a surface of the cylindrical plate base material; and a hydrophobic resist pattern part which is formed on the satin-like rough surface, wherein an exposed part of the satin-like rough surface serves as a non-printing area and the resist pattern part serves as a printing area.

## Description

### Technical Field

The present invention relates to a seamless cylindrical offset printing plate, which is free from a seam and is to be used in offset printing, a manufacturing method for the seamless cylindrical offset printing plate, and a reproduction processing method for the seamless cylindrical offset printing plate.

### Background Art

A general offset printing system is a printing system of performing printing which involves forming satin-like fine roughness on a surface of a plate material (which is also called a plate) made of, for example, aluminum, forming a printing area and a non-printing area through use of a photosensitive material to provide a plate, winding the plate around a plate cylinder, transferring an ink supplied to a plate surface to a rubber blanket, and inserting paper between the rubber blanket and an impression cylinder. In printing, an oil-based ink is supplied to the printing area, and water (also containing a small amount of isopropyl alcohol) called dampening water is supplied to the non-printing area, to thereby perform printing through repulsion between water and oil. For example, in Patent Document 1, there is described a related-art manufacturing method for an offset printing plate.

Meanwhile, when the plate is wound around the plate cylinder as described above, a seam is inevitably formed between both end portions of the plate wound around the plate cylinder. When such a seam is formed, an image cannot be formed at the seam portion, and hence there is a problem in that seamless continuous printing cannot be performed.

### Prior Art Documents

### Patent Documents

Patent Document 1: JP Sho48-49501 A

### Summary of the Invention

### Problems to be solved by the Invention

It is an object of the present invention to provide a seamless cylindrical offset printing plate, which enables seamless continuous printing to be performed, a manufacturing method for the seamless cylindrical offset printing plate, and a reproduction processing method for the seamless cylindrical offset printing plate.

### Means for Solving Problems

In order to solve the above-mentioned problem, a seamless cylindrical offset printing plate according to the present invention comprises: a cylindrical plate base material; a hydrophilic satin-like rough surface which is formed on a surface of the cylindrical plate base material; and a hydrophobic resist pattern part which is formed on the satin-like rough surface, wherein an exposed part of the satin-like rough surface serves as a non-printing area and the resist pattern part serves as a printing area.

A manufacturing method for a seamless cylindrical offset printing plate according to the present invention comprises: preparing a cylindrical plate base material; forming a hydrophilic satin-like rough surface on a surface of the cylindrical plate base material; and forming a hydrophobic resist pattern part by applying a resist to the satin-like rough surface and subjecting the resist to laser exposure and development, wherein an exposed part of the satin-like rough surface serves as a non-printing area and the resist pattern part serves as a printing area.

A reproduction processing method for a seamless cylindrical offset printing plate according to the present invention comprises, after performing offset printing through use of the said seamless cylindrical offset printing plate, removing the resist pattern part by subjecting a surface of the seamless cylindrical offset printing plate after the offset printing to at least one treatment selected from the group consisting of ultrasonic cleaning treatment, chemical cleaning treatment, microbubble cleaning treatment, sandblasting treatment and liquid honing treatment, to thereby provide a reproduced cylindrical plate base material having the satin-like rough surface formed on the surface of the cylindrical plate base material.

### Advantageous Effects of the Invention

According to the present invention, there is provided a remarkable effect of being capable of providing the seamless cylindrical offset printing plate which enables seamless continuous printing to be performed, the manufacturing method therefor, and the reproduction processing method.

### Brief Description of Drawings

FIG. 1 is a sectional view of an essential part for illustrating an embodiment of a seamless cylindrical offset printing plate according to the present invention.

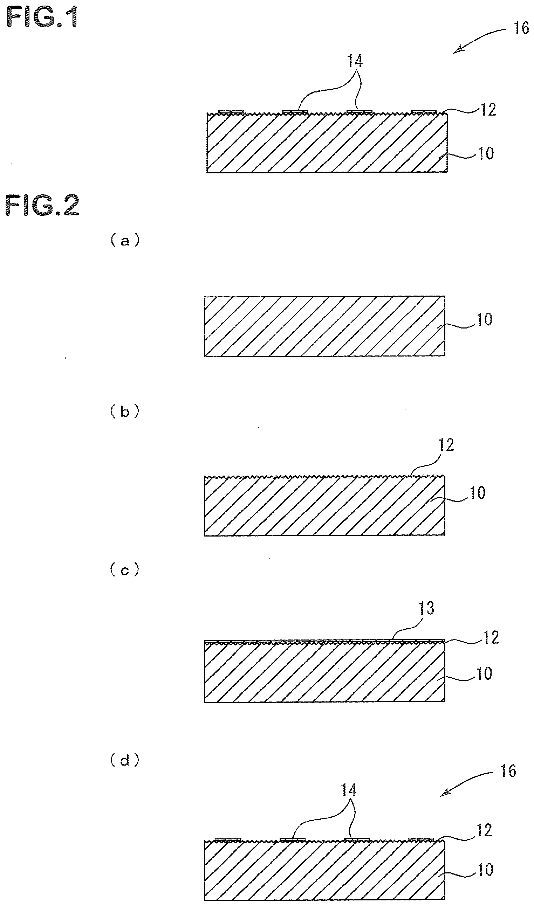

FIG. 2 shows sectional views of essential parts for schematically illustrating a manufacturing method for the seamless cylindrical offset printing plate according to the present invention, wherein the part (a) is an illustration of a state in which a cylindrical plate base material is prepared, the part (b) is an illustration of a state in which a satin-like rough surface is formed on a surface of the cylindrical plate base material, the part (c) is an illustration of a state in which a resist is applied to the satin-like rough surface, and the part (d) is an illustration of a state in which a resist pattern part is formed by exposure and development.
FIG. 3 is a schematic overall view of an essential part of an offset printing apparatus using the seamless cylindrical offset printing plate according to the present invention.

### Modes for Carrying out the Invention

Embodiments of the present invention are described below. However, the embodiments are described as examples, and hence it is understood that various modifications may be made thereto without departing from the technical spirit of the present invention. In addition, the same members are denoted by the same reference symbols.

An embodiment of a seamless cylindrical offset printing plate according to the present invention is illustrated in FIG. 1. In FIG. 1, the reference symbol 16 denotes an offset printing plate of the present invention.

The seamless cylindrical offset printing plate 16 according to the present invention is a seamless cylindrical offset printing plate, which is free from a seam. The seamless cylindrical offset printing plate 16 comprises a hollow cylindrical plate base material 10, a hydrophilic satin-like rough surface 12 formed on a surface of the plate base material 10, and a hydrophobic resist pattern part 14 formed on the satin-like rough surface 12.

In the seamless cylindrical offset printing plate 16, the satin-like rough surface 12 is hydrophilic, and hence an exposed part of the satin-like rough surface 12 serves as a non-printing area (area to which an ink does not adhere by being repelled by dampening water). The resist pattern part 14 is hydrophobic, and hence serves as a printing area (area to which an ink adheres).

FIG. 2 shows sectional views of essential parts for schematically illustrating a manufacturing method for the seamless cylindrical offset printing plate 16 according to the present invention.

First, the hollow cylindrical plate base material 10 is prepared (the part (a) of FIG. 2). As a material for the cylindrical plate base material, a metal such as aluminum or iron is suitable. Then, satin-like fine roughness is formed on a surface of the cylindrical plate base material 10 by treatment, for example, sandblasting to form the satin-like rough surface 12 (the part (b) of FIG. 2). When the satin-like rough surface 12 is formed as described above, dampening water applied to the satin-like rough surface 12 is retained thereon, and hence a hydrophilic surface is obtained.

Then, a resist (photosensitive material) 13 is applied to the satin-like rough surface 12 (the part (c) of FIG. 2). The resist pattern part 14 is formed by drying and then subjecting the resist 13 to laser exposure and development with a laser exposure device (the part (d) of FIG. 2). The resist pattern part 14 is hydrophobic, and hence serves as the printing area. An application thickness of the photosensitive material 13 is preferably from about 0.1 µm to about 10 µm. With this, the exposed part of the satin-like rough surface 12 is formed. The exposed part of the satin-like rough surface 12 serves as the non-printing area, and the resist pattern part 14 serves as the printing area. Thus, the offset printing plate 16 is completed.

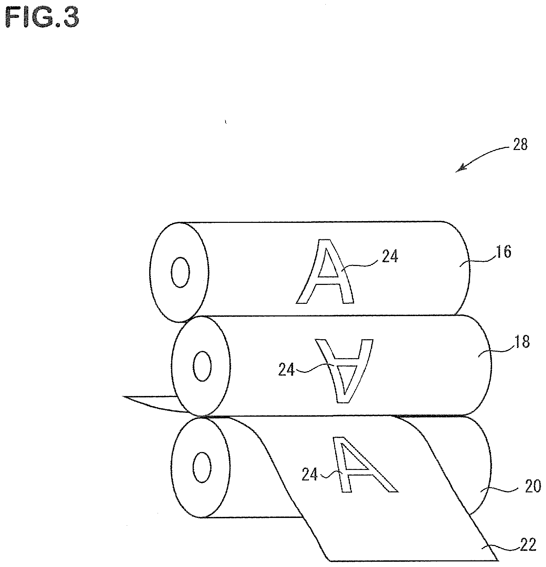

Next, an embodiment of an offset printing apparatus using the offset printing plate 16 according to the present invention is illustrated in FIG. 3.

In FIG. 3, the reference symbol 28 denotes an offset printing apparatus. The offset printing apparatus 28 is an offset printing apparatus comprising the offset printing plate 16, a blanket cylinder 18, and an impression cylinder 20, and printing is performed on a material 22 to be printed with an ink 24. In the illustrated example, paper is exemplified as the material 22 to be printed, but a plastic film or the like can also be used.

Further, after offset printing is performed through use of the seamless cylindrical offset printing plate 16 as illustrated in FIG. 3, the resist pattern part 14 is removed by subjecting a surface of the seamless cylindrical offset printing plate 16 after the offset printing to at least one treatment selected from the group consisting of ultrasonic cleaning treatment, chemical cleaning treatment, microbubble cleaning treatment, sandblasting treatment and liquid honing treatment. Thus, it is possible to provide a reproduced cylindrical plate base material having the satin-like rough surface 12 formed on the surface of the cylindrical plate base material 10.

The ultrasonic cleaning treatment can be performed, for example, by irradiating the surface of the seamless cylindrical offset printing plate 16 with an ultrasonic wave while the seamless cylindrical offset printing plate 16 is immersed in water. With this, the resist pattern part 14 can be removed.

The chemical cleaning treatment can be performed by applying an alkaline solution to the surface of the seamless cylindrical offset printing plate 16. With this, the resist pattern part 14 can be removed. As the alkaline solution, for example, a sodium hydroxide aqueous solution having a sodium hydroxide concentration of from 1% to 20% can be used. Further, the chemical cleaning treatment can be performed by applying a solvent to the surface of the seamless cylindrical offset printing plate 16. With this, the resist pattern part 14 can be removed. As the solvent, for example, an alcohol or methyl ethyl ketone (MEK) can be used.

The microbubble cleaning treatment can be performed, for example, by generating microbubbles in which fine gas (for example, air) is dissolved in water through use of a microbubble generator to generate microbubbles while the seamless cylindrical offset printing plate 16 is immersed in water, to thereby perform cleaning with the microbubbles. With this, the resist pattern part 14 can be removed. As the microbubble generator, a commercially available device can be used.

The sandblasting treatment can be performed by spraying an abrasive material, for example, sand to the surface of the seamless cylindrical offset printing plate 16. With this, the resist pattern part 14 can be removed.

The liquid honing treatment can be performed by jetting slurry having fine abrasive grains dispersed therein to the surface of the seamless cylindrical offset printing plate 16 with compressed air at a high speed. With this, the resist pattern part 14 can be removed.

Two or more kinds of treatment for removing the resist pattern part described above may be combined.

As described above, according to the reproduction processing method for the seamless cylindrical offset printing plate according to the present invention, a reproduced cylindrical plate base material having the satin-like rough surface 12 formed on the surface of the cylindrical plate base material 10 can be obtained by removing the resist pattern part 14. Then, through the step of forming a hydrophobic resist pattern part by applying the resist again to the satin-like rough surface 12, drying the resist, and then subjecting the resist to laser exposure and development, a reproduced seamless cylindrical offset printing plate is obtained.

### Reference Signs List

10: cylindrical plate base material, 12: satin-like rough surface, 13: photosensitive material, 14: resist pattern part, 16: offset printing plate, 18: blanket cylinder, 20: impression cylinder, 22: material to be printed, 24: ink, 28: offset printing apparatus.

## Claims

1. A seamless cylindrical offset printing plate comprising:
a cylindrical plate base material;
a hydrophilic satin-like rough surface which is formed on a surface of the cylindrical plate base material; and
a hydrophobic resist pattern part which is formed on the satin-like rough surface,
wherein an exposed part of the satin-like rough surface serves as a non-printing area, and the resist pattern part serves as a printing area.

2. A manufacturing method for a seamless cylindrical offset printing plate comprising:
preparing a cylindrical plate base material;
forming a hydrophilic satin-like rough surface on a surface of the cylindrical plate base material; and
forming a hydrophobic resist pattern part by applying a resist to the satin-like rough surface and subjecting the resist to laser exposure and development,
wherein an exposed part of the satin-like rough surface serves as a non-printing area and the resist pattern part serves as a printing area.

3. A reproduction processing method for a seamless cylindrical offset printing plate comprising,
after performing offset printing through use of the seamless cylindrical offset printing plate of claim 1,
removing the resist pattern part by subjecting a surface of the seamless cylindrical offset printing plate after the offset printing to at least one treatment selected from the group consisting of ultrasonic cleaning treatment, chemical cleaning treatment, microbubble cleaning treatment, sandblasting treatment and liquid honing treatment, to thereby provide a reproduced cylindrical plate base material having the satin-like rough surface formed on the surface of the cylindrical plate base material.
